# EUROPÄISCHE PATENTSCHRIFT

(11) **EP 2 677 675 B1**
(45) Veröffentlichungstag und Bekanntmachung des Hinweises auf die Patenterteilung: **03.05.2017**
(21) Anmeldenummer: 13172792.7
(22) Anmeldetag: 19.06.2013
(51) Int. Cl.: H04B 17/00, H03M 7/16

(54) **Analyse eines über ein Übertragungsmedium übertragenen Mischsignals**
Analysis of a mixed signal transferred via a transfer medium
Analyse d'un signal de mélange transmis via un fluide de transmission

(30) Priorität: 21.06.2012 DE 102012105400
(43) Veröffentlichungstag der Anmeldung: 25.12.2013
(73) Patentinhaber: wiseSense GmbH, 30159 Hannover (DE)
(72) Erfinder: Wilzeck, Dr. Andreas, 30989 Gehrden (DE); Dimitrov, Emil, 30159 Hannover (DE)
(74) Vertreter: Kröncke, Rolf

(56) Entgegenhaltungen:
- WO-A1-03/049310
- US-A1- 2005 227 625
- US-A1- 2007 064 833

## Beschreibung

Die Erfindung betrifft ein Verfahren zur Analyse eines über ein Übertragungsmedium übertragenen Mischsignals gemäß dem Anspruch 1. Die Erfindung betrifft ferner einen Signalanalysator gemäß Anspruch 7 sowie ein Computerprogramm gemäß Anspruch 8.

Die Analyse eines Mischsignals ist z. B. aus der US 6,690,746 B1 bekannt. Das dortige Verfahren ist nur begrenzt geeignet für eine Langzeitbeobachtung und - dokumentation der auftretenden Signalanteile des Mischsignals und deren effiziente Verarbeitung. Eine umfassende Analyse von Funknetzen, z. B. in industriellen Fertigungsstätten, erfordert in manchen Fällen eine tage- oder wochenlange Beobachtung und Auswertung der Daten. Bei den auftretenden großen Frequenzbereichen, die bis in den Gigahertz-Bereich reichen, sind die dabei zu erfassenden, zu verarbeitenden und zu speichernden Datenmengen extrem groß.

Aus der WO 03/049310 A1 ist eine Einrichtung und ein Verfahren für eine digitale Breitbanduntersuchung und Analyse für Signale mit wechselnden Frequenzen (frequency hopping) bekannt.

Der Erfindung liegt daher die Aufgabe zugrunde, eine wirtschaftlich günstigere Lösung für die Analyse von Problemen in Funknetzen anzugeben, insbesondere wenn dort nur sporadisch einzelne Störungen auftreten.

Diese Aufgabe wird durch ein Verfahren zur Analyse eines über ein Übertragungsmedium übertragenen Mischsignals gemäß Anspruch 1 gelöst.

Die Erfindung hat den Vorteil, dass der Signalanalysator den Signalverlauf des ggf. sehr hochfrequenten Mischsignals nicht pauschal speichert, sondern eine Detektion von Signalereignissen durchführt, die Signalereignisse extrahiert und diese Signalereignisse speichert. Dies erlaubt eine erhebliche Reduktion des zu speichernden Datenvolumens des Mischsignals, Vorteilhaft können die Signalereignisse sehr speicherplatzsparend codiert werden, so dass deren Speicherung relativ günstig möglich ist. Durch die Transformation des Mischsignals in Signalereignisse und die Speicherung der Signalereignisse kann über einen langen Zeitraum mit wenig Speicherplatzbedarf eine Information über das Verhalten eines beobachteten Funknetzes erfasst und für eine spätere Analyse bereitgehalten werden.

Das Übertragungsmedium kann im Falle drahtloser Übertragung ein Funkkanal sein, oder bei drahtgebundener Übertragung eine Übertragungsleitung, z. B. eine elektrische (galvanische) Leitung oder eine Glasfaserleitung,

Die Detektion eines Signalereignisses kann z. B. durch Vergleich bestimmter Dateninhalte des Mischsignals bzw. daraus erzeugter Daten mit vorbestimmten Datenmustern erfolgen. Die Datenmuster können in einer Musterdatenbank in Form von durch a priori Wissen spezifizierte, erwartete Signalereignisse definiert werden.

Gemäß einer vorteilhaften Weiterbildung der Erfindung wird ein Signalereignis durch eine Dateneinheit repräsentiert, in der wenigstens der Signaltyp und/oder der Typ des Signalerzeugers, der Zeitpunkt des Auftretens eines Signals des erkannten Signaltyps bzw. Signalerzeugertyps sowie dessen Trägerfrequenz gespeichert sind. Dies erlaubt eine kompakte, speicherplatzsparende Speicherung der Signalereignisse mit einer ausreichenden Information, die auch eine spätere Langzeitanalyse erlaubt. Als unterschiedliche Signaltypen werden z. B. WLAN-Signale, Bluetooth-Signale oder Mobiltelefon-Signale verstanden. Der Signaltyp kann zudem mit weiteren Verfeinerungen unterschieden werden, z. B. zwischen dem WLAN-Standard WLAN-B und WLAN-G. Es können auch noch weitere Verfeinerungen der Unterscheidung vorgesehen sein, z. B. Unterscheidungen nach den Derivaten der verwendeten Funkstandards, so dass der Typ des Signalerzeugers auch hinsichtlich des eingesetzten Funksignalstandard-Derivats identifiziert werden kann.

Gemäß einer vorteilhaften Weiterbildung der Erfindung wird bei einer ersten Klasse von Signalereignissen der Signalverlauf des Mischsignals nicht gespeichert oder aus einem Speicher wieder gelöscht und bei einer zweiten, anderen Klasse von Signalereignissen werden wenigstens bestimmte Zeitabschnitte des Signalverlaufs des Mischsignals gespeichert und die gespeicherten Zeitabschnitte des Signalverlaufs des Mischsignals in einer zusätzlichen Detailanalyse weiter analysiert werden und/oder für Dokumentationszwecke aufbewahrt. Dies hat den Vorteil, dass der Signalanalysator den Signalverlauf des ggf. sehr hochfrequenten Mischsignals nicht pauschal speichert, sondern nur im Falle bestimmter Signalereignisse Speicherplatz damit belegt. Dies erlaubt eine erhebliche Reduktion des zu speichernden Datenvolumens, ohne die Auswertungs- und Dokumentationsmöglichkeiten einzuschränken.

In einer vorteilhaften Weiterbildung der Erfindung umfasst die erste Klasse von Signalereignissen solche Signalereignisse, die bereits ohne weitere Detailanalyse, allein aufgrund einer einfach und schnell durchzuführenden Voranalyse, eindeutig hinsichtlich des Signaltyps bzw. des Typs des Signalerzeugers identifiziert werden können. Die zweite Klasse von Signalereignissen umfasst dann solche Signalereignisse, die keine oder keine eindeutige Identifikation des Signaltyps bzw. des Signalerzeugertyps aufgrund der Voranalyse erlaubt.

Gemäß einer vorteilhaften Weiterbildung der Erfindung erfolgt zunächst keine Speicherung des Signalverlaufs des Mischsignals. Bei Auftreten von Signalereignissen der zweiten Klasse erfolgt die Speicherung des Signalverlaufs des Mischsignals. Die Signalereignisse der zweiten Klasse triggern damit sozusagen die Speicherung des Signalverlaufs des Mischsignals. Dies hat den Vorteil, dass der für die Speicherung des Mischsignals verwendete Speicher nicht permanent vollläuft, sondern deutlich sparsamer mit dem vorhandenen Speicherplatz umgegangen wird. Vorteilhaft werden dann Signalabschnitte des Signalverlaufs des Mischsignals gespeichert, in denen wiederum Signalereignisse der zweiten Klasse, die für die Auslösung der Speicherung verantwortlich sind, wiederum auftreten, so dass diese später anhand der gespeicherten Mischsignaldaten einer Detailanalyse unterzogen werden können. Dies ist insbesondere vorteilhaft, wenn die Signalereignisse der zweiten Klasse keine oder keine genaue Identifikation des Signaltyps bzw. des Signalerzeugertyps erlauben.

Gemäß einer vorteilhaften Weiterbildung der Erfindung erfolgt eine Speicherung des Signalverlaufs des Mischsignals. Bei Auftreten von Signalereignissen der ersten Klasse werden zumindest Abschnitte des gespeicherten Signalverlaufs des Mischsignals aus dem Speicher gelöscht. Auf diese Weise kann der Speicher "aufgeräumt" verwerden und solche Signalabschnitte des Mischsignals, die ohnehin nur bereits identifizierte Signaltypen bzw. Signalerzeugertypen aufweisen, können gelöscht werden. Hierdurch entsteht deswegen kein Informationsverlust, weil eine entsprechende, stärker komprimierte Information durch die abgespeicherten Signalereignisse der ersten Klasse vorhanden ist.

Die Speicherung des Signalverlaufs des Mischsignals kann hierbei pauschal erfolgen, d. h. ohne irgendwelche Triggerbedingungen. Die Speicherung kann auch zusätzlich mit einer Triggerung aufgrund bestimmter Ereignisse durchgeführt werden, z. B. bei Auftreten von Signalereignissen der zweiten Klasse.

Gemäß der Erfindung wird das Mischsignal über eine Eingangsschaltung des Signalanalysators empfangen und in digitale Daten gewandelt, wobei die digitalen Daten in einen Thermometercode mit fester Datenlänge gewandelt werden. Dies hat den Vorteil, dass mit einfachen und schnell auszuführenden Konvertierungsschritten, die auch von einfacher, preisgünstiger Hardware ausgeführt werden können, eine schnelle Umwandlung in gut verarbeitbare Daten erfolgt. Hierdurch ist insbesondere eine Echtzeit-Verarbeitung der eingehenden großen Datenströme des Mischsignals mit preisgünstiger Hardware möglich. Durch die Umwandlung in einen Thermometercode mit fester Datenlänge kann eine erhebliche Datenkompression erfolgen. Der damit einhergehende Informationsverlust ist nicht problematisch, da
die verbleibenden Charakteristika der Daten nach wie vor eine Unterscheidung der Signalanteile des Mischsignals im Hinblick auf die zu erkennenden Signaltypen bzw. Signalerzeugertypen erlauben. Ein weiterer Vorteil der angegebenen Codierung ist, dass die Weiterverarbeitung der im Thermometercode in fester Datenlänge codierten Daten sehr einfach, schnell und implementierungsfreundlich erfolgen kann. So kann eine besonders aufwandsgünstige Fusion zwischen Datenblöcken mittels eines binären XORs erfolgen. Zudem können aufwandsgünstige weitere Codierverfahren und binäre Maskierungstechniken zur Extraktion von wesentlichen Signalkenngrößen angewandt werden. Hierdurch kann das Verfahren auch günstig in anwendungsspezifischen Bausteinen, sog. ASICs, oder in FGPAs implementiert werden.

Gemäß der Erfindung wird das Mischsignal vor der Umwandlung in den Thermometercode jeweils zeitlich blockweise für eine vorbestimmte Anzahl von Abtastwerten mittels einer Frequenzbereichstransformation in den Frequenzbereich gewandelt und dann die Umwandlung in den Thermometercode durchgeführt. Dies hat den Vorteil, dass der Thermometercode bereits Daten in einer Darstellung im Frequenzbereich aufweist, was die Erkennung bestimmter Frequenzmuster vereinfacht. Als Frequenzbereichstransformation kann z.B. eine Fast-Fourier-Transformation (FFT) mit fester Blocklänge verwendet werden.

Gemäß der Erfindung werden die im Thermometercode vorliegenden Daten in einer wenigstens dreidimensionalen Matrixform verarbeitet. Auch dies ist für eine Verarbeitung der Daten durch preisgünstige einfache Hardware förderlich. Zur Bestimmung bestimmter Signaleigenschaften, um letztendlich Signalereignisse zu detektieren und zu extrahieren, können z. B. in verschiedenen Ebenen Schnitte durch die mehrdimensionale Matrix gelegt werden und die in diesem Schnitt enthaltenen Daten jeweils ausgewertet werden. Dies ist mit einfachen binären Operationen möglich.

Gemäß einer vorteilhaften Weiterbildung der Erfindung werden zur Suche eines Signalereignisses die Daten in der dreidimensionalen Matrixform schichtweise auf das Vorhandensein vordefinierter Datenmuster untersucht. Die vordefinierten Datenmuster können dabei in einem Musterspeicher abgelegt sein, der aufgrund von a priori Kenntnissen der zu identifizierenden Signaltypen bzw. der Signalerzeugertypen mit den zugehörigen Datenmustern belegt ist.

Gemäß einer vorteilhaften Weiterbildung der Erfindung werden Signalanteile des Mischsignals, die anhand der detektierten Signalereignisse nicht bereits eindeutig einem Signaltyp bzw. einem Signalerzeugertyp zugeordnet werden können, einer Detailanalyse zugeführt, in der eine Identifikation von unterschiedlichen Typen von Signalen bzw. Signalerzeugern anhand gespeicherter, vordefinierter Charakteristika von bekannten Funksystem- und Signalstandards durchgeführt wird. Dies erlaubt eine feinere Detailanalyse der Signalanteile des Mischsignals, so dass eine höhere Erfolgsquote bei der Identifikation der Signaltypen bzw. Signalerzeugertypen erzielt werden kann.

Die eingangs genannte Aufgabe wird ferner gemäß Anspruch 7 gelöst durch einen Signalanalysator, der wenigstens aufweist:
- einen ersten Speicher, in dem ein Computerprogramm gespeichert ist,
- einen zweiten Speicher, in dem die Signalereignisse gespeichert oder zu speichern sind,
- einen dritten Speicher, in dem wenigstens bestimmte Zeitabschnitte des Signalverlaufs des Mischsignals gespeichert oder zu speichern sind,
- einen Rechner, der Zugriff auf den ersten, den zweiten und den dritten Speicher hat,
wobei der Signalanalysator eingerichtet zur Ausführung eines Verfahrens der zuvor erläuterten Art ist, wenn das Computerprogramm auf dem Rechner ausgeführt wird.

Die eingangs genannte Aufgabe wird außerdem gemäß Anspruch 8 gelöst durch ein Computerprogramm, mit Programmcodemitteln, insbesondere gespeichert auf einem maschinenlesbaren Träger, eingerichtet zur Durchführung eines Verfahrens der zuvor erläuterten Art, wenn das Computerprogramm auf einem Rechner ausgeführt wird.

Die Erfindung wird nachfolgend anhand von Ausführungsbeispielen unter Verwendung von Zeichnungen näher erläutert.

Es zeigen:
- Figur 1: einen Signalanalysator in schematischer Darstellung und
- Figur 2: ein die Funktion des Signalanalysators beschreibendes Blockdiagramm und
- Figur 3: ein weiteres die Funktion des Signalanalysators beschreibendes Blockdiagramm.

In den Figuren werden gleiche Bezugszeichen für einander entsprechende Elemente verwendet.

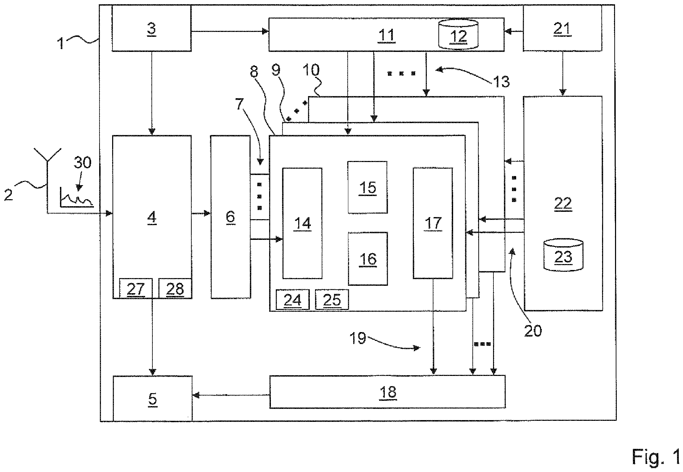

Der in Figur 1 dargestellte Signalanalysator 1 empfängt über ein Übertragungsmedium ein Mischsignal 30, wobei hier angenommen ist, dass das Mischsignal 30 über eine Antenne 2 empfangen wird. Das Mischsignal 30 wird einer Voranalyseeinheit 4 zugeführt. Die Voranalyseeinheit 4 weist eingangsseitig ein Hochfrequenzempfangsmodul auf, das das Mischsignal 30 von einem vorgegebenen Frequenzbereich mit einer vorbestimmten Bandbreite der Hochfrequenzlage auf eine Zwischenfrequenzlage oder direkt in ein Basisband transformiert. In der Voranalyseeinheit 4 wird das hierdurch erzeugte analoge Zwischenfrequenzsignal bzw. Basisbandsignal dann mit einem Tiefpass gefiltert (Anti-Aliasing-Filter), abgetastet und digitalisiert. Die abgetasteten digitalen Daten werden in einem Signalspeicher des Signalanalysators 1 für die weitere Verarbeitung zwischengespeichert. Auf diesen Signalspeicher können die Voranalyseeinheit 4 sowie die noch zu erläuternden Analysatorfinger zugreifen.

Die Voranalyseeinheit 4 führt weist außerdem einen Rechner 28 und einen Speicher 27 auf, in dem ein vom Rechner auszuführendes Computerprogramm gespeichert ist.

Die Voranalyseeinheit 4 führt sodann eine Unterscheidung der zu erkennenden Signale von Rauschsignalen durch. Aus den hierbei ermittelten Signalanteilen werden mittels Filterung, Detektionsverfahren und Parameterschätzverfahren die Kandidatentypen von Signalerzeugern bestimmt und in Form von jeweiligen Parameterdaten charakterisiert. Die Parameterdaten werden von der Voranalyseeinheit 4 dann einer Fingerzuweisungslogik 6 übergeben. Die Fingerzuweisungslogik 6 erzeugt aus den Parameterdaten Analyseaufträge, wobei jeder Analyseauftrag zur Identifikation eines Kandidatentypen von Signalerzeuger dient. Die Fingerzuweisungslogik 6 verteilt die Analyseaufträge dann je nach aktueller Auslastung der in dem Signalanalysator 1 vorhandenen Analysatorfingern 8, 9, 10 auf diese Analysatorfinger, wobei jeweils ein Analyseauftrag einem Analysatorfinger 8, 9, 10 zugewiesen wird. Dies ist in der Figur 1 durch die Pfeile 7 dargestellt, wobei durch die jeweils drei Punkte zwischen den Pfeilen bzw. zwischen den Analysatorfingern 8, 9, 10 angedeutet werden soll, dass es sich um eine grundsätzlich beliebige Anzahl von Analysatorfingern handeln kann, zur Vereinfachung aber nur beispielhaft drei Analysatorfinger dargestellt sind.

Bei der Fingerzuweisungslogik 6 handelt es sich um eine Kontrollinstanz, die entweder in Form einer Warteschlange, nach Priorität oder manueller Vorgabe Analyseaufträge den Analysatorfingern 8, 9, 10 zuweist. Hierzu wird die vermutete Trägerfrequenz, die Signalbandbreite und der Zeitabschnitt der Aktivität an den Analysatorfinger 8, 9, 10 übergeben. Der Analysatorfinger analysiert dann den hierdurch definierten Zeit- und Frequenzabschnitt der in dem Speicher gespeicherten digitalen Daten des Mischsignals 30.

Ein Analysatorfinger 8, 9, 10 weist jeweils ein Vorverarbeitungsmodul 14, ein Eigenschaftsdetektionsmodul 15, ein Parameterschätzungsmodul 16 sowie ein Signalklassifikationsmodul 17 auf. Die genannten Module 14, 15, 16, 17 sind dynamisch anhand von Daten aus einer Regelwerk-Datenbank 12 und einem Repositorium 23 rekonfigurierbar. Ein Analysatorfinger 8, 9, 10 weist außerdem jeweils einen Rechner 25 und einen Speicher 24 auf, in dem ein vom Rechner auszuführendes Computerprogramm gespeichert ist.

Hierzu weist der Signalanalysator 1 einen Speicher 11 auf, in dem die Regelwerk-Datenbank 12 gespeichert ist. Die Regelwerk-Datenbank 12 enthält Expertenwissen über bekannte Funksystem- und Signalstandards, die zu einer eindeutigen Identifikation des Funksystem- oder Signalstandards führen, z. B. in der Art:
1. Eine Liste A mit Informationen der Funkfrequenzregulierung (z. B. dem an der Örtlichkeit geltenden (z. B. nationalen) Frequenzzuweisungsplan) und die damit verknüpften zulässigen Frequenzzugangsmechanismen.
2. Eine Liste B der Funk- und Signalstandards ergänzt um die spezifischen Informationen
   a. genutzte Frequenzbereiche
   b. genutzte HF Brandbreiten
   c. genutzte Frequenzzugangsmechanismen
   d. Verbreitung des Funksystem- bzw. Signalstandards (ggf. als anwendungs- bzw. branchen-spezifische Voreinstellung)
3. Eine Liste C die je Funksystem- und Signalstandard
   a. die festzustellenden charakteristischen Merkmale sowie
   b. die jeweils zur Feststellung des Merkmals zugehörigen und der Reihe nach auszuführenden spezifischen Realisierungen von Funktionen bzw. Verfahren.

Ein festzustellendes charakteristisches Merkmal der Liste C kann hierbei ein messbarer bzw. durch statistische Verfahren abschätzbarer Parameter (z. B. Trägerfrequenz, Bandbreite, Crest-Faktor, Periodizität von Korrelationen, Unterträgerabstand, Framelänge, Symboldauer, Periode, Duty Cycle) sein oder auch eine Eigenschaft (z. B. Verhalten über Zeit und Frequenz, Ein- oder Mehrträgermodulation, eingebettete Strukturen, Modulationsart, Symbolalphabet, mögliche Kanalmittenfrequenzen usw.).

Merkmale auf Basis von messbaren oder abschätzbaren Parametern werden als Wert oder Wertebereich oder als Mittelwert und Standardabweichung charakterisiert. Für die zur Messung oder Schätzung heranzuziehende Realisierung wird eine Bewertung hinsichtlich ihrer grundsätzlichen Zuverlässigkeit für die Aufgabe hinterlegt.

Merkmale auf Basis einer Eigenschaft werden abstrakt als "vorhanden" oder "nicht vorhanden" o. ä. behandelt und zusätzlich die typischen Wahrscheinlichkeiten für Detektion und Fehlalarm spezifisch für die zu nutzenden Realisierung angegeben.

Neben etablierten Funksystem- und Signalstandards umfasst die Regelwerk-Datenbank 12 proprietäre Funklösungen sowie Derivate, die sich durch anwendungsspezifische oder herstellerspezifische Modifikationen von in den Standards festgelegten Varianten unterscheiden können, z. B. durch andere Frequenzsprungweiten, Frequenzzugangsmechanismen, Framelängen, Duty Cycle.

Ferner weist der Signalanalysator 1 ein in einem Speicher 22 gespeichertes Repositorium 23 auf. Das Repositorium 23 enthält Computerprogrammmodule, mit denen spezifische Realisierungen von Funksystem- und Signalstandards in Signalerzeugern nachgebildet werden können. Die Computerprogrammmodule können als Objektcode oder Firmware in einer von einem Analysatorfinger ausführbaren Form gespeichert sein.

Ein Analysatorfinger 8, 9, 10 führt einen zugewiesenen Analyseauftrag wie folgt aus. Gemäß dem von der Fingerzuweisungslogik 6 zugewiesenen Parameterdatensatz wird der Analysatorfinger entsprechend den Vorgaben aus der Regelwerk-Datenbank 12 rekonfiguriert, d. h. spezifisch an die zu bewältigende Aufgabe angepasst. Dies ist in der Figur 1 durch die Pfeile 13 dargestellt. Diese Anpassung kann durch Anpassung von Softwarefunktionen oder in Form von rekonfigurierbaren Hardwarebausteinen des Analysatorfingers, z. B. Array-Prozessoren, durchgeführt werden. Zudem werden in den Analysatorfinger die notwendigen Realisierungen der Methoden bzw. Funktionen der zu identifizierenden Typen von Signalerzeugern durch Einladen von einem oder mehreren Computerprogrammmodulen aus dem Repositorium 23 übertragen. Dies ist in der Figur 1 durch die Pfeile 20 dargestellt. Zunächst wird eine Rekonfiguration des Vorverarbeitungsmoduls 14 des Analysatorfingers durchgeführt. Hierdurch wird das Vorverarbeitungsmodul 14 auf die durch das Vorverarbeitungsmodul 14 durchzuführende digitale Bandpassfilterung konfiguriert, auf die Änderung der Abtastrate, der Skalierung des Wertebereichs und der Frequenzlage des zu identifizierenden Signalanteils des Kandidatentyps. Die hierzu benötigten Parameter und Vorgaben hinsichtlich der anzuwendenden Methoden und zu verwendenden Realisierungen erhält der Analysatorfinger aus der zuvor genannten Liste C der Regelwerk-Datenbank 12.

Als zweiter Schritt wird eine Rekonfiguration der Analyse-Funktionen des Analysatorfingers durchgeführt. Hierzu werden das Eigenschaftsdetektionsmodul 15, das Parameterschätzungsmodul 16 und das Signalklassifikationsmodul 17 entsprechend rekonfiguriert. Diese Analyse-Funktionen dienen der Feststellung von spezifischen Merkmalen von Signalanteilen des Kandidatentyps. Sie umfassen Methoden zur Messung bzw. Schätzung von Parametern und die Extraktion von Signaleigenschaften. Die anzuwendenden Methoden, deren Reihenfolge und die Nutzung einer parallelen Ausführung verschiedener Methoden sowie die jeweils zu nutzende Realisierung werden entsprechend den Vorgaben aus der Liste C der Regelwerk-Datenbank 12 entnommen.

In einem dritten Schritt erfolgt eine Klassifikation bzw. Identifikation eines Funksystem- und Signalstandards. Dies wird anhand von bereits festgestellten Merkmalen durch erneuten Abgleich mit Daten aus der Regelwerk-Datenbank 12 (Listen A, B und C) nach einem iterativen Prinzip durchgeführt. Die Identifikation erfolgt direkt oder über alle möglichen Kandidatentypen nach dem Ausschlussprinzip, wobei auch zuvor ausgeschlossene Kandidatentypen aufgrund einer Null-Bewertung der erkannten Merkmale in Folge der iterativen Ausführung wieder hinzutreten können. Zusätzlich wird hierbei ermittelt, wie sicher die Identifikation ist und welche Wahrscheinlichkeiten für das Zutreffen der ermittelten Identifikation des Typs des Signalerzeugers gelten.

Wenn der Analysatorfinger seinen Analyseauftrag abgeschlossen hat, übergibt dieser als Ergebnis den identifizierten Typ des Signalerzeugers hinsichtlich des Funksystem- und Signalstandards sowie eine Angabe über die Wahrscheinlichkeit einer korrekten Identifikation an einen Ergebnisspeicher 18, die sog. Radio Environment Map, aus. Diese repräsentiert den Zustand des Übertragungsmediums und verzeichnet dessen Ursachen, z. B. Signalquellen wie z. B. Radar-Funksysteme und Störquellen, sowie die zugrunde liegenden Funksystem- und Signalstandards. Die Radio Environment Map steht fortlaufend aktualisiert externen Anwendungen über eine externe Schnittstelle 5 zur Verfügung. Über die externe Schnittstelle 5 können die Inhalte der Radio Environment Map ausgelesen werden, bzw. aktiv von dem Signalanalysator 1 ausgegeben werden. Die externe Schnittstelle 5 kann z. B. mit einem Computermonitor oder einem Computer zur weiteren Auswertung der Daten verbunden werden. Über die externe Schnittstelle 5 können auch von der Voranalyseeinheit 4 ermittelte Daten ausgegeben werden.

An die externe Schnittstelle 5 können ferner rekonfigurierbare Network Sniffer, Radio Resource Manager, Netzwerkmanager und Reportgeneratoren angeschlossen werden.

Die vorgenannten Schritte werden iterativ durchlaufen, bis eine eindeutige bzw. hinreichend sichere Identifikation oder eine hinreichend gute Klassifikation erreicht wurde oder zumindest eine vorgegebene Anzahl von Iterationsschritten durchgeführt wurde. Hierfür verwendete Schwellwerte für die Anzahl der Iterationsschritte oder die Genauigkeit der Identifikation oder Klassifikation können dabei an dem Signalanalysator 1 von einem Benutzer eingestellt werden.

Ferner ist eine externe Schnittstelle 3 vorgesehen, über die Einstellungen an der Voranalyseeinheit 4 oder der Regelwerk-Datenbank 12 vorgenommen werden können.

Des Weiteren ist eine Aktualisierungsschnittstelle 21 vorgesehen, über die Aktualisierungen der Regelwerk-Datenbank 12 und des Repositoriums 23 durchgeführt werden können. Hierfür kann ein Rechner an die Aktualisierungsschnittstelle 21 angeschlossen werden und entsprechend aktualisierte Daten in den Speicher 11 oder den Speicher 22 einschreiben. Die aktualisierten Daten können einem Benutzer beispielsweise über das Internet zur Verfügung gestellt werden.

Die Radio Environment Map 18 enthält Informationen über die Funkumgebung an der Örtlichkeit der durchgeführten Analyse. In Multisensor-Anwendungen kann diese auch mehrere verschiedene Örtlichkeiten wiedergeben. Die Radio Environment Map enthält hierneben Informationen über das Vorhandensein von Signalanteilen bestimmter Stärke auch Informationen zu den Signaleigenschaften sowie zu den möglichen Signalerzeugern und den von denen verwendeten Funksystem- und Signalstandards.

Bei der Abarbeitung des Analyseauftrags in dem Analysatorfinger können vielfältige Signalvorverarbeitungen, Parameterschätzungen und Eigenschaftsdetektionen zur Anwendung kommen. Diese Analyseschritte können ggf. auch parallelisiert innerhalb eines Analysatorfingers durchgeführt werden. In einem solchen Fall weist dann ein Analysatorfinger ggf. mehrere Vorverarbeitungsmodule, Eigenschaftsdetektionsmodule und Parameterschätzungsmodule auf. Auch der Einsatz von spezialisierten Hardware-Beschleunigungsmodulen kann vorteilhaft vorgesehen werden.

Es kann auch vorgesehen sein, dass in jedem Schritt, den ein Analysatorfinger durchführt, eine Tabelle in der Radio Environment Map generiert oder aktualisiert wird, die die bisher erkannten Eigenschaften sowie die noch möglichen Signalklassen unter Angabe ihrer Wahrscheinlichkeit oder Zuverlässigkeit enthält.

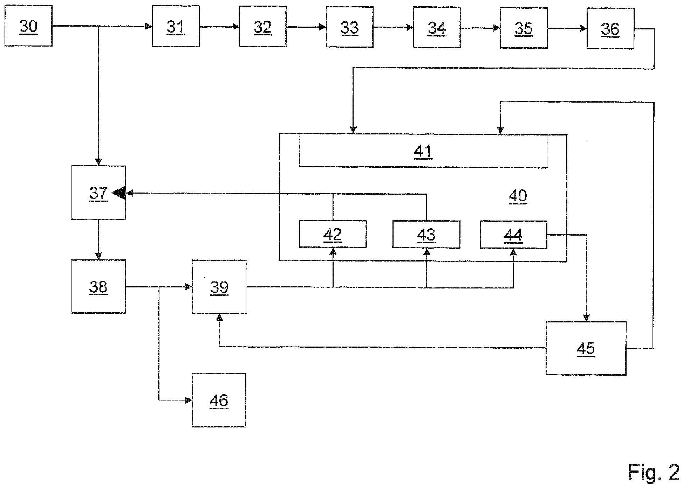

Die Figur 2 zeigt in Blockdiagrammdarstellung einen Funktionsablauf bei einer Analyse eines über das Übertragungsmedium übertragenen Mischsignals 30.

Zunächst sei wiederum davon ausgegangen, dass das Mischsignal 30, hier durch einen Block 30 dargestellt, eingespeist und analysiert wird. Das Mischsignal 30 wird zunächst einer Reihe von Blöcken 31 bis 36 zugeführt, die z. B. Teil der Voranalyseeinheit 4 sein können. In einem Block 31 wird das analoge Eingangssignal in digitale Daten überführt, z. B. mittels Analog/DigitalWandlung. Eine vorgeschaltete Empfangsschaltung kann beispielsweise zusätzlich eine Schaltung zur Frequenzfilterung und Anpassung der Frequenzlage des empfangenen Mischsignals aufweisen. Aus dem Block 31 werden die digitalisierten Abtastwerte des Mischsignals einem Block 32 zugeführt, in dem eine N-Punkt Fast Fourier Transformation durchgeführt wird. Vom Block 32 wird als Ausgangsgröße ein Block von N Werten als Ergebnis der Transformation an einen Block 33 abgegeben. Im Block 33 werden jeweils empfangene N Werte eines Blocks mit Hilfe des Thermometercodes jeweils in einen Vektor fester Länge gewandelt. Als Beispiel sei angenommen, dass der Dynamikbereich der N Werte 55 beträgt. Die Länge des Thermometercodes sei 8 Bit, d. h. es sollen jeweils Vektoren mit 8 Bit erzeugt werden. Hieraus ergibt sich, dass acht Stufen zur Verfügung stehen. Hieraus ergibt sich eine Stufenhöhe von 55 / 8 = 7 (gerundet). Wenn z. B. der Wert 20 als ein Ergebniswert der FourierTransformation in den Thermometercode gewandelt werden soll, folgt hieraus, dass der Wert 20 durch die Stufenhöhe 7 geteilt wird, was die gerundet Zahl 3 ergibt. Dies führt in der Codierung des Thermometercodes zu der Bitfolge 11100000, also drei Einsen, die übrigen Bitpositionen sind mit Nullen aufgefüllt. Es handelt sich hierbei lediglich um Beispielwerte. Die Länge des Thermometercodes bzw. des Vektors ergibt sich letztlich durch den abzudeckenden Dynamikbereich und der Stufung des Thermometercodes.

In einem auf den Block 33 folgenden Funktionsblock 34 werden die N Thermometercodevektoren der einen N-Punkt Fast Fourier Transformation zu einer Matrix mit L Zeilen und N Spalten zusammengefügt. Die Größe L entspricht hierbei der Zahl der Stufenschwellen, d. h. der Bitlänge des Thermometercodes. Diese Schritte werden fortlautend für M Blöcke von jeweils N Abtastwerten durchgeführt. In einem Block 35 werden die im Block 34 erzeugten L x N-Matrizen in eine binäre Kubusform der Dimension L x N x M überführt. Auf die in diesem Kubus gespeicherten Daten werden nun die weiteren Verarbeitungsschritte bezogen. In einem auf den Block 35 folgenden Block 36 wird eine Zeit- und Frequenzanalyse durchgeführt, mit dem Ziel der Signalklassifikation von Anteilen des Mischsignals als Signalereignis. Die Ergebnisse der Zeit- und Frequenzanalyse im Block 36 werden einem Verarbeitungs- und Steuerblock 40 zugeführt. In dem Verarbeitungs- und Steuerblock 40 erfolgt zunächst in einem Block 41 eine Klassifikation der in der zuvor genannten Art ausgewerteten Daten. Die Daten werden in Ereignisklassen "unbekannt" (Block 42), "vage" (Block 43) und "klar" (Block 44) klassifiziert und in entsprechenden Listen gespeichert. Die im Block 44 als "klar" identifizierten Signalereignisse bedürfen keiner weiteren Analyse mehr, sondern sind durch die zuvor beschriebene Analyse bereits eindeutig klassifiziert. Diese Signalereignisse werden dann in einem Signalereignisspeicher 45 gespeichert. Der Signalereignisspeicher 45 kann auch Teil der Radio Environment Map 18 sein. Die als "unklar" oder "vage" eingestuften Signalereignisse in den Blöcken 42 und 43 dienen als Triggergröße für einen Block 37. Über den Block 37 wird ein Aufzeichnen von bestimmten Zeitabschnitten des Signalverlaufs des Mischsignals 30 gesteuert. Vorteilhaft werden dabei Signalabschnitte aufgezeichnet, in denen die unklaren oder vagen Signalereignisse erneut auftauchen. Bei entsprechender Triggerung lässt der Triggerblock 37 das Mischsignal zu einem Block 38 durch, in dem eine temporäre Speicherung des Mischsignals durchgeführt wird. Das temporär gespeicherte Mischsignal wird anschließend in einem Block 39 einer Detailanalyse zugeführt, z. B. einer Detailanalyse in einem Analysatorfinger 8, 9, 10 des Signalanalysators 1. Zusätzlich werden zumindest bestimmte gespeicherte Zeitabschnitte des Mischsignals einer dauerhaften Signalspeicherung in einem Block 46 zugeführt. Hier erfolgt insbesondere eine dauerhafte Speicherung von auch nach einer Detailanalyse nicht klassifizierbaren Signalabschnitten. Die dauerhaft gespeicherten Signalabschnitte können beispielsweise einer externen, ggf. manuellen Signaluntersuchung zugeführt werden.

Die durch die Detailanalyse im Block 39 gefundenen Ergebnisse führen zu einer Aktualisierung der vorläufigen Signalklassifizierung in den Blöcken 42, 43, 44. Im Regelfall wird dabei für eine oder mehrere Signalereignisse der Klasse "unbekannt" oder "vage" eine Umklassifikation in die Klasse "klar" durchgeführt, d. h. der Inhalt in den Blöcken 42, 43 reduziert sich und der Inhalt im Block 44 erhöht sich. Entsprechend werden weitere klare Signalereignisse dem Signalereignisspeicher 45 zugeführt.

Die im Block 39 durchgeführte Detailanalyse kann zusätzlich auf bereits erkannte Signalereignisse im Block 45 zurückgreifen, um hierdurch die Detailanalyseergebnisse zu verbessern. Zusätzlich können die Ergebnisse im Signalereignisspeicher 45 auch rekursiv dem Klassifikationsblock 41 zugeführt werden, so dass der Signalanalysator 1 in der Art eines selbstlernenden Systems von zuvor bereits erkannten Signalereignissen auf ggf. zu erwartende weitere Signalereignisse schließen kann.

Die Triggerung im Block 37 kann auch durch ein externes Signal erfolgen. In diesem Fall weist der Signalanalysator einen externen Triggereingang auf, über den Triggersignale direkt dem Block 37 zugeführt werden können.

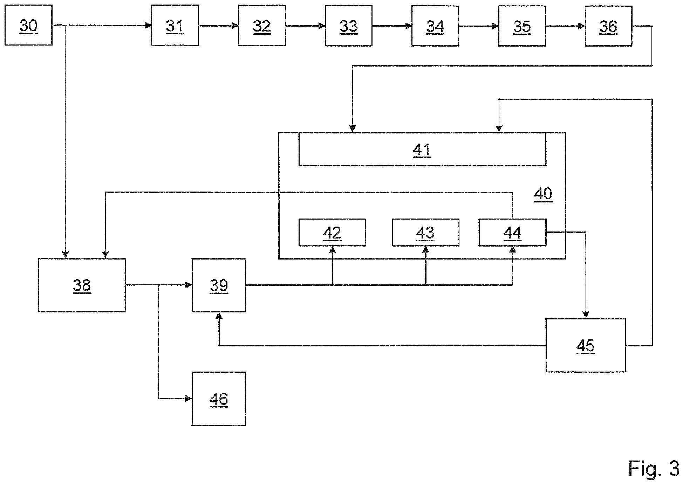

Die Figur 3 zeigt ebenfalls in Blockdiagrammdarstellung die Funktion des Signalanalysators 1 ähnlich wie Figur 2, jedoch mit dem Unterschied, dass der Triggerblock 37 nicht vorgesehen ist. Stattdessen erfolgt pauschal eine Speicherung des Mischsignals im Block 38. Da eine dauerhafte Speicherung des Mischsignals 30 aus Laufzeit- und Speicherplatzgründen nicht sinnvoll ist, ist zusätzlich vorgesehen, dass die als "klar" erkannten Signalereignisse dazu genutzt werden, den Pufferspeicher im Block 38 sozusagen wieder "aufzuräumen", d. h. solche Abschnitte des Mischsignals wieder zu löschen, die bereits ausreichend durch die im Signalereignisspeicher 45 gespeicherten Signalereignisse dokumentiert sind.

Für die Zeit- und Frequenzanalyse wird der zuvor bereits erläuterte Datenkubus herangezogen. Dieser hat folgende Vorteile:
1. Es ist eine einfach verarbeitbare Matrix mit Daten vorhanden, die die im Mischsignal enthaltenen Frequenzen der Amplitude nach in Binärsignal-Folgen darstellt.
2. Durch die beschriebene Umwandlung in den Thermometercode wurden Schwellwerte, d. h. Stufen, durch einfache Umformungen erzeugt, ohne dass eine fallbasierte Verarbeitung in einem Prozessor erforderlich ist. Insbesondere kann auf rechenzeitaufwändige Fallunterscheidungen wie if-Abfragen oder case-Konstrukte verzichtet werden.
3. Durch die Umformung wurde die Auflösung der Werte z. B. von 16 Bit auf eine Amplitudenstufung der Werte von nur 8 Stufen, d. h. einen Informationsgehalt von 3 Bit, reduziert. Zur einfachen Weiterverarbeitung werden diese allerdings als 8 Bit-Vektor dargestellt.
4. Mit der genannten Datenumformung in Form des binären Codes kann auch auf einfache und wenig rechenzeitaufwändige Weise eine Fusion von Daten aus mehreren Eingangsschaltungen durch ein einfaches binäres XOR, d. h. ein Exclusiv-Oder, der jeweiligen Kubusdaten erfolgen. Ggf. ist eine Anpassung der jeweiligen Kuben in der Dimension und/oder Überlappung erforderlich.

Wie erwähnt, liegen die Daten in dem Kubus der Dimension L x N x M vor. Für die Analyse dieser Daten wird von einem Koordinatensystem mit den Achsen I (Wertebereich O...L), n (Wertebereich O...N) und m (Wertebereich O...M) ausgegangen. Für eine Durchführung einer Zeit- und Frequenzanalyse auf Basis der Kubusdaten kann in Frequenzrichtung eine Analyse durchgeführt werden durch einen Schnitt parallel zur n-Achse, in Zeitrichtung eine Analyse durch einen Schnitt parallel zur m-Achse oder auch in einer Schicht, aufgespannt in Frequenz- und Zeitrichtung durch einen Schnitt senkrecht zur I-Achse. Die entsprechenden Verarbeitungsschritte sind sehr implementierungsfreundlich, da der Kubus nur aus binären Nullen und Einsen besteht.

Zunächst sei beispielhaft eine Frequenzanalyse betrachtet. Jeder Schnitt durch den Datenkubus parallel zur n-Achse liefert Ergebnisse von Energiedetektionen in Frequenzrichtung. Im Gegensatz zur klassischen Energiedetektion mit nur einem Schwellwert liegen im Datenkubus aber bereits mehrere Schwellwertunterscheidungen in Form der z.B. acht Stufen vor, d. h. es sind mehrere Schwellwerte in Amplitudenrichtung vorhanden. Hierdurch kann vorteilhaft das Mischsignal entsprechend seiner Amplitudenstufung schichtweise analysiert werden. Mit den folgenden Schritten lassen sich Schicht für Schicht durch den Datenkubus mögliche Bandbreiten und Trägerfrequenzen der im Mischsignal enthaltenen Signalanteile extrahieren.
1. Start der Analyse der obersten Schicht I=L.
2. Lauflängencodierung in n-Richtung der Schicht.
3. Suche mit Hilfe von a priori Wissen (z. B. nach Regelwerk mögliche Bandbreiten und Trägerfrequenzen) nach Signalen sowie allen aufgrund der beobachteten Muster möglichen Klassifikationen.
4. Eintragung der möglichen Klassifikationen als Kandidaten in eine für die Schicht spezifischen Tabelle.
5. Eintragung von Signalen in eine Tabelle "unbekannt", die die Schwelle der Schicht überschritten haben, aber keinem a priori Wissen zuzuordnen sind.
6. Fortsetzung bei Schritt 2. mit der darunterliegenden Schicht I=L-1, bis die unterste Schicht verarbeitet ist.
7. Bereinigung der Tabelle "unbekannt" von Einträgen, die auf anderen Schichten erfolgreich mit a priori Wissen einem Kandidatensignal zugeordnet werden konnten.

Eine Zeitanalyse kann wie folgt durchgeführt werden. Jeder Schnitt durch den Datenkubus parallel zur m-Achse liefert Ergebnisse von Energiedetektionen in Zeitrichtung. Im Gegensatz zur klassischen Energiedetektion werden jedoch für mehrere Schwellwerte in Amplitudenrichtung Ergebnisse geliefert. Ähnlich wie zuvor zu der Frequenzanalyse erläutert, lassen sich nun Schicht für Schicht mögliche Belegungsdauern und Zeitraster der Signale sowie deren statistische Zeitverhalten extrahieren.

Die vorgenannten Schritte können zu einer kombinierten Zeit- und Frequenzanalyse kombiniert werden. Hierbei wird blockweise eine Zeit- und Frequenzanalyse durch Schnitte senkrecht zur I-Achse durchgeführt. Es wird nach Kandidaten gesucht, die in der Schicht ein Rechteck aufspannen, wobei für die Position in Frequenz- und Zeitrichtung sowie für die belegte Bandbreite und belegte Dauer Randbedingungen aus a priori Wissen allgemein bekannt sind und in Form von Regeln zur Klassifikation herangezogen werden, z. B. durch Speicherung in der Regelwerk-Datenbank 12. Die Zeit- und Frequenzanalyse kann beispielhaft mit folgenden Schritten durchgeführt werden:
1. Start mit der Analyse der obersten Schicht I=L.
2. Suche mit Hilfe von a priori Wissen nach Signalmustern und aller aufgrund der beobachteten Muster möglichen Klassifikationen.
3. Eintragung der möglichen Klassifikationen als Kandidaten in eine für die Schicht spezifischen Tabelle.
4. Eintragung von Signalen in eine Tabelle "unbekannt", die die Schwelle der Schicht überschritten haben, aber keinem a priori Wissen zuzuordnen sind.
5. Fortsetzung bei Schritt 2. mit der darunterliegenden Schicht I=L-1, bis die unterste Schicht verarbeitet ist.
6. Bereinigung der Tabelle "unbekannt" von Einträgen, die auf anderen Schichten erfolgreich mit a priori Wissen einem Kandidatensignal zugeordnet werden konnten.

Hiernach liegt je Schicht eine Liste von Kandidaten vor, die anhand von a priori Wissen einer Vorklassifikation unterworfen wurden. Es können in der Kandidaten-Klassifikation Mehrdeutigkeiten auftreten, d. h. ein Signalereignis hat mehrere Klassifikationsmöglichkeiten. Es liegt außerdem je Schicht eine Liste von unbekannten Signalen vor, die keinem a priori Wissen zugeordnet werden konnten. Die mehrdeutigen Klassifikationen "unbekannt" und "vage" werden der Detailanalyse im Block 39 zugeführt. Ist diese Analyse erfolgreich, d. h. führt zu einer eindeutigen Signalklassifikation eines Signalereignisses, wird die Mehrdeutigkeit in den Kandidatenlisten "unbekannt" bzw. "vage" bereinigt, und die Liste "klar" um das entsprechende Signalereignis ergänzt. Andernfalls verbleibt der Kandidat in der jeweiligen Liste und es wird die jeweilige Sicherheit der Klassifikation in Form einer Wahrscheinlichkeit ausgegeben.

Vorteilhafterweise werden die zuvor beispielhaft beschriebenen Prozesse zur Zeit- und/oder Frequenzanalyse mit einer Redundanzreduktion durch eine anpassbare Vorfilterung/Maskierung ausgestattet.

Hierdurch lässt sich bereits erlangtes Wissen aus zuvor analysierten Schichten gemeinsam mit dem a priori Wissen verwenden und die Suche nach Mustern in der weiteren Verarbeitung optimieren, d. h. die Ergebnisse der bislang durchlaufenen Schichten werden kombiniert mit der aktuell verarbeiteten Schicht betrachtet.

## Patentansprüche

1. Verfahren, ausgeführt durch einen Signalanalysator (1), zur Analyse eines über ein Übertragungsmedium übertragenen Mischsignals (30), das mehrere von unterschiedlichen Signalerzeugern erzeugte Signalanteile aufweist,
- wobei mittels des Signalanalysators das Mischsignal analysiert wird,
- wobei der Signalanalysator in dem Mischsignal Signalereignisse detektiert, diese extrahiert und speichert,
- wobei bei einer ersten Klasse (44) von Signalereignissen nur das extrahierte Signalereignis gespeichert wird und der Signalverlauf des Mischsignals nicht gespeichert oder aus einem Speicher wieder gelöscht wird,
**dadurch gekennzeichnet, dass**
bei einer zweiten, anderen Klasse (42, 43) von Signalereignissen wenigstens bestimmte Zeitabschnitte des Signalverlaufs des Mischsignals gespeichert werden und die gespeicherten Zeitabschnitte des Signalverlaufs des Mischsignals in einer zusätzlichen Detailanalyse (39) weiter analysiert werden,
- wobei das Mischsignal in einem ersten Schritt (31) über eine Eingangsschaltung des Signalanalysators empfangen und in digitale Daten gewandelt wird,
- wobei die digitalen Daten in einem zweiten Schritt (32) jeweils zeitlich blockweise für eine vorbestimmte Anzahl von Abtastwerten mittels einer Frequenzbereichstransformation in den Frequenzbereich gewandelt werden,
- wobei die frequenzbereichstransformierten Daten in einem dritten Schritt (33) in einen Thermometercode mit fester Datenlänge gewandelt werden, indem übrige Bitpositionen in der Codierung des Thermometercodes mit Nullen aufgefüllt werden, und
- wobei die im Thermometercode vorliegenden Daten in folgenden Schritten (34, 35) in eine dreidimensionale Matrixform der Dimension LxNxM überführt und weiter verarbeitet werden, wobei L die Bitlänge des Thermometercodes ist und N und M vordefinierte Werte sind.

2. Verfahren nach Anspruch 1, **dadurch gekennzeichnet, dass** ein Signalereignis durch eine Dateneinheit repräsentiert wird, in der wenigstens der Signaltyp und/oder der Typ des Signalerzeugers, der Zeitpunkt des Auftretens eines Signals des erkannten Signaltyps bzw. Signalerzeugertyps sowie dessen Trägerfrequenz gespeichert sind,

3. Verfahren nach einem der vorhergehenden Ansprüche, **dadurch gekennzeichnet, dass** zunächst keine Speicherung des Signalverlaufs des Mischsignals (30) erfolgt und bei Auftreten von Signalereignissen der zweiten Klasse (42, 43) die Speicherung des Signalverlaufs des Mischsignals (30) erfolgt.

4. Verfahren nach einem der vorhergehenden Ansprüche, **dadurch gekennzeichnet, dass** eine Speicherung des Signalverlaufs des Mischsignals (30) erfolgt und bei Auftreten von Signalereignissen der ersten Klasse (44) zumindest Abschnitte des gespeicherten Signalverlaufs des Mischsignals (30) aus dem Speicher gelöscht werden.

5. Verfahren nach einem der vorhergehenden Ansprüche, **dadurch gekennzeichnet, dass** zur Suche eines Signalereignisses die Daten in der dreidimensionalen Matrixform schichtweise auf das Vorhandensein vordefinierter Datenmuster untersucht werden,

6. Verfahren nach einem der vorhergehenden Ansprüche, **dadurch gekennzeichnet, dass** Signalanteile des Mischsignals (30), die anhand der detektierten Signalereignisse nicht bereits eindeutig einem Signaltyp bzw. einem Signalerzeugertyp zugeordnet werden können, einer Detailanalyse zugeführt werden, in der eine Identifikation von unterschiedlichen Typen von Signalen bzw. Signalerzeugern anhand gespeicherter, vordefinierter Charakteristika von bekannten Funksystem- und Signalstandards durchgeführt wird.

7. Signalanalysator (1), der wenigstens aufweist:
- einen ersten Speicher (24, 27), in dem ein Computerprogramm gespeichert ist,
- einen zweiten Speicher (18, 45), in dem die Signalereignisse gespeichert oder zu speichern sind,
- einen dritten Speicher (38, 46), in dem wenigstens bestimmte Zeitabschnitte des Signalverlaufs des Mischsignals (30) gespeichert oder zu speichern sind,
- einen Rechner (25, 28), der Zugriff auf den ersten, den zweiten und den dritten Speicher (18, 24, 27, 38, 45, 46) hat,
wobei der Signalanalysator (1) eingerichtet zur Ausführung eines Verfahrens nach einem der vorhergehenden Ansprüche ist, wenn das Computerprogramm auf dem Rechner (25, 28) ausgeführt wird.

8. Computerprogramm mit Programmcodemitteln, insbesondere gespeichert auf einem maschinenlesbaren Träger, eingerichtet zur Durchführung des Verfahrens nach einem der Ansprüche 1 bis 6, wenn das Computerprogramm auf einem Rechner (25, 28) ausgeführt wird.

## Claims

1. Method, carried out by a signal analyser (1), for analysing a mixed signal (30) that is transmitted via a transmission medium and that has multiple signal components generated by different signal generators,
- wherein the signal analyser is used to analyse the mixed signal,
- wherein the signal analyser detects signal events in the mixed signal, extracts them and stores them,
- wherein for a first class (44) of signal events only the extracted signal event is stored and the signal profile of the mixed signal is not stored or is erased from a memory again,
**characterized in that**
for a second, different class (42, 43) of signal events at least determined time periods of the signal profile of the mixed signal are stored and the stored time periods of the signal profile of the mixed signal are analysed further in an additional detail analysis (39),
- wherein the mixed signal, in a first step (31), is received via an input circuit of the signal analyser and is converted into digital data,
- wherein the digital data are respectively converted, in a second step (32), into the frequency domain in blocks over time for a predetermined number of samples by means of a frequency domain transformation,
- wherein the data transformed to the frequency domain are converted, in a third step (33), into a thermometer code having a fixed data length by filling the remaining bit positions in the coding of the thermometer code with zeros, and
- wherein the data available in the thermometer code are transferred, in subsequent steps (34, 35), to a three-dimensional matrix form of dimension LxNxM and are processed further, L being the bit length of the thermometer code and N and M being predefined values.

2. Method according to Claim 1, **characterized in that** a signal event is represented by a data unit in which at least the signal type and/or the type of the signal generator, the time of occurrence of a signal of the identified signal type or signal generator type and the carrier frequency thereof are stored.

3. Method according to either of the preceding claims, **characterized in that** initially the signal profile of the mixed signal (30) is not stored and the signal profile of the mixed signal (30) is stored on the occurrence of signal events of the second class (42, 43).

4. Method according to one of the preceding claims, **characterized in that** the signal profile of the mixed signal (30) is stored and at least sections of the stored signal profile of the mixed signal (30) are erased from the memory on the occurrence of signal events of the first class (44).

5. Method according to one of the preceding claims, **characterized in that** searching for a signal event involves the data in the three-dimensional matrix form being examined in layers for the presence of predefined data patterns.

6. Method according to one of the preceding claims, **characterized in that** signal components of the mixed signal (30) that are not already able to be biuniquely associated with a signal type or with a signal generator type on the basis of the detected signal events are supplies to a detail analysis in which an identification of different types of signals or signal generators is performed on the basis of stored, predefined characteristics of known radio system and signal standards.

7. Signal analyser (1) that has at least:
- a first memory (24, 27) in which a computer program is stored,
- a second memory (18, 45) in which the signal events are stored or are to be stored,
- a third memory (38, 46) in which at least determined time periods of the signal profile of the mixed signal (30) are stored or are to be stored,
- a computer (25, 28) that has access to the first, the second and the third memory (18, 24, 27, 38, 45, 46),
the signal analyser (1) being set up to carry out a method according to one of the preceding claims, when the computer program is executed on the computer (25, 28).

8. Computer program having program code means, particularly stored on a machine-readable storage medium, set up to perform the method according to one of Claims 1 to 6 when the computer program is executed on a computer (25, 28).

## Revendications

1. Procédé, mis en oeuvre par l'intermédiaire d'un analyseur de signal (1), pour analyser un signal de mélange (30) transmis par l'intermédiaire d'un support de transmission, qui comporte plusieurs parties de signal générées par des générateurs de signal différents,
- dans lequel le signal de mélange est analysé au moyen de l'analyseur de signal,
- dans lequel l'analyseur de signal détecte des événements de signal dans le signal de mélange, les extrait et les stocke,
- dans lequel, pour une première classe (44) d'événements de signal, seul l'événement de signal extrait est stocké et l'évolution de signal du signal de mélange n'est pas stockée ou n'est pas de nouveau effacée d'une mémoire,
**caractérisé en ce que**,
pour une deuxième classe (42, 43) différente d'événements de signal, au moins certaines périodes de temps déterminée de l'évolution de signal du signal de mélange sont stockées et les périodes de temps stockées de l'évolution de signal du signal de mélange sont de nouveau, analysées lors d'une analyse détaillée supplémentaire (39),
- dans lequel le signal de mélange est reçu lors d'une première étape (31) par l'intermédiaire d'un circuit d'entrée de l'analyseur de signal et est converti en données numériques,
- dans lequel les données numériques sont converties dans, le domaine fréquentiel lors d'une deuxième étape (32) par blocs temporels respectifs pour un nombre prédéterminé de valeurs d'échantillonnage au moyen d'une transformation de domaine fréquentiel,
- dans lequel les données transformées dans le domaine fréquentiel sont converties en un code de thermomètre ayant une longueur de données fixe lors d'une troisième étape (33) en remplissant de zéros d'autres positions binaires dans le codage du code de thermomètre, et
- dans lequel les données présentes dans le code de thermomètre sont transférées sous la forme d'une matrice tridimensionnelle de dimension LxNxM et soumises à un traitement supplémentaire lors d'étapes suivantes (34, 35), dans lequel L est la longueur binaire du code de thermomètre et N et M sont des valeurs prédéfinies.

2. Procédé selon la revendication 1, **caractérisé en ce qu'**un événement de signal est représenté par une unité de données dans laquelle sont au moins stockés le type de signal et/ou le type du générateur de signal, l'instant de l'apparition d'un signal du type de signal reconnu ou du type de générateur reconnu ainsi que sa fréquence porteuse.

3. Procédé selon l'une quelconque des revendications précédentes, **caractérisé en ce qu'**en premier lieu, aucun stockage de l'évolution de signal du signal de mélange (30) n'est effectué, et **en ce que**, lors de l'apparition d'événements de signal appartenant à la deuxième classe (42, 43), le stockage de l'évolution de signal du signal de mélange (30) est effectué.

4. Procédé selon l'une quelconque des revendications précédentes, **caractérisé en ce qu'**un stockage de l'évolution de signal du signal de mélange (30) est effectué, et **en ce que**, lors de l'apparition d'événements de signal appartenant à la première classe (44), au moins certaines parties de l'évolution de signal stockée du signal de mélange (30) sont effacées de la mémoire.

5. Procédé selon l'une quelconque des revendications précédentes, **caractérisé en ce que**, pour rechercher un événement de signal, les données sont examinées couche par couche sous la forme d'une matrice tridimensionnelle pour déterminer la présence de configurations de données prédéfinies.

6. Procédé selon l'une quelconque des revendications précédentes, **caractérisé en ce que** des parties de signal du signal de mélange (30) qui peuvent être associées à un type de signal ou à un type de générateur de signal non déjà unique sur la base des événements de signal détectés, sont soumises à une analyse détaillée lors de laquelle une identification de différents types de signaux ou dé générateurs de signaux est effectuée sur la base de caractéristiques stockées et prédéfinies de normes connues de systèmes radio et de signaux.

7. Analyseur de signal (1), comprenant au moins :
- une première mémoire (24, 27) dans laquelle est stocké un programme d'ordinateur,
- une deuxième mémoire (18, 45) dans laquelle sont stockés ou doivent être stockés les événements de signal,
- une troisième mémoire (38, 46) dans laquelle sont stockées ou doivent être stockées au moins certaines périodes de temps déterminées de l'évolution de signal du signal de mélange (30),
- un calculateur (25, 28) ayant accès aux première, deuxième et troisième mémoires (18, 24, 27, 38, 45, 46), dans lequel l'analyseur de signal (1) est conçu pour mettre en oeuvre un procédé selon l'une quelconque des revendications précédentes lorsque le programme d'ordinateur est exécuté sur le calculateur (25, 28).

8. Programme d'ordinateur comportant des moyens à code de programme, notamment stockés sur un support lisible par machine, conçus pour mettre en oeuvre le procédé selon l'une quelconque des revendications 1 à 6 lorsque le programme d'ordinateur est exécuté sur un calculateur (25, 28).
